## Europäisches Patentamt

## European Patent Office

## Office européen des brevets

(11) Publication number: **0 303 257**
**A1**

## (12) EUROPEAN PATENT APPLICATION

(21) Application number: **88113015.7**

(22) Date of filing: **10.08.88**

(51) Int. Cl.⁴: **H03K 17/22**

(30) Priority: **13.08.87 JP 202385/87**

(43) Date of publication of application:
**15.02.89 Bulletin 89/07**

(84) Designated Contracting States:
**DE FR GB**

(71) Applicant: **KABUSHIKI KAISHA TOSHIBA
72, Horikawa-cho Saiwai-ku
Kawasaki-shi Kanagawa-ken 210(JP)**

(72) Inventor: **Kinugasa, Masanori c/o Patent
Division
Kabushiki Kaisha Toshiba 1-1 Shibaura
1-chome
Minato-ku Tokyo 105(JP)**
Inventor: **Tanaka, Fuminari c/o Patent Division
Kabushiki Kaisha Toshiba 1-1 Shibaura
1-chome
Minato-ku Tokyo 105(JP)**
Inventor: **Arakawa, Osamu c/o Patent Division
Kabushiki Kaisha Toshiba 1-1 Shibaura
1-chome
Minato-ku Tokyo 105(JP)**

(74) Representative: **Henkel, Feiler, Hänzel &
Partner
Möhlstrasse 37
D-8000 München 80(DE)**

(54) **Reset signal generating circuit.**

(57) A reset signal generating circuit includes a first capacitor (3) connected between a first power source terminal (Vcc) and an output node (A), an N-channel MOS transistor (4) whose current path is connected between the output node (A) and a second power source terminal (Vss), and a discharging control circuit for turning on the N-channel MOS transistor (4) after a power source voltage which is supplied between the first and second power source terminals (Vcc and Vss) has started to rise. In the reset signal generating circuit, the discharging control circuit includes a P-channel MOS transistor (1) which has a gate connected to the second power source terminal (Vss) and a current path directly connected between the first power source terminal (Vcc) and the gate of the N-channel MOS transistor (4) and a second capacitor (2) connected between the gate of the N-channel MOS transistor (4) and the second power source terminal (Vss).

F I G. 3

## Reset signal generating circuit

This invention relates to a reset signal generating circuit which is, for example, provided in a semiconductor integrated circuit chip to set the internal circuit to the initial condition.

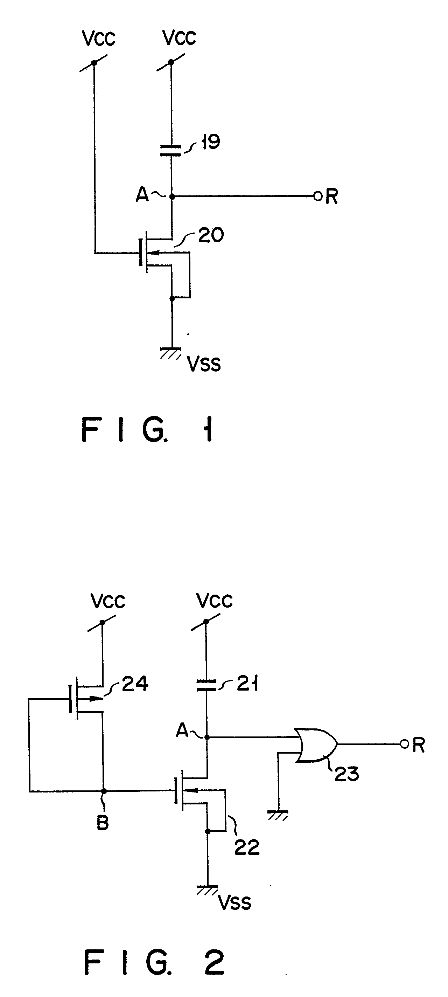

Fig. 1 is a circuit diagram showing the construction of the conventional reset signal generating circuit. Capacitor 19 is connected at one end to power source voltage terminal Vcc and at the other end to the drain of N-channel MOS transistor 20. The gate of transistor 20 is connected to voltage terminal Vcc, and a connection node between transistor 20 and capacitor 19 is used to output a reset signal.

Next, the operation of the circuit is explained briefly. When the power source is turned on, capacitor 19 is charged. When the potential at node A rises with the potential rise in power source voltage Vcc, a reset signal is generated. When voltage Vcc has reached threshold voltage Vthn of MOS transistor 20, MOS transistor 20 is turned on to discharge capacitor 19. As a result, the potential at node A is set to a low level, interrupting generation of the reset signal.

In the conventional circuit as described above, the reset signal is generated in the case where power source voltage Vcc rises at a relatively high rate. However, if power source voltage Vcc rises relatively slowly in comparison with the time constant determined by the ON-resistance of MOS transistor 20 and the capacitance of capacitor 19, MOS transistor 20 will be turned on to discharge capacitor 19 before the potential at node A becomes sufficiently high. In this case, the reset signal will not be generated. In order to generate the reset signal even when the time constant is set to be large in comparison with the rise time of power source voltage Vcc, it is necessary to increase the capacitance of capacitor 19 or increase the ON-resistance of MOS transistor 20. In a case where the size of capacitor 19 or the gate length of MOS transistor 20 is increased to meet the requirement, the area of the reset signal generating circuit will be enlarged and resultantly the chip size of the semiconductor integrated circuit may be increased. In order to prevent increase in the chip size, it becomes necessary to arrange the capacitor and resistor outside the semiconductor integrated circuit chip.

Fig. 2 is a circuit diagram showing another conventional circuit in which the above defect is overcome. The drain of N-channel MOS transistor 22 is connected to power source terminal Vcc via capacitor 21 and the source thereof is grounded. Connection node A between the drain of MOS transistor 22 and capacitor 21 is connected to a first input terminal of OR gate 23 whose second input terminal is grounded. The output terminal of OR gate 23 is used to generate a reset signal. The source of P-channel MOS transistor 24 is connected to power source terminal Vcc, and the drain and gate thereof are connected to node B and to the gate of MOS transistor 22.

Now, the operation of the circuit of Fig. 2 is explained. After the power source is turned on, the potential at node A rises with the rise in power source voltage Vcc. At this time, the potential of the output terminal of OR gate 23 is raised to a high level, thus generating a reset signal. If, in this case, the absolute value of the threshold voltage of P-channel MOS transistor 24 is represented by $|$ Vthp $|$, the potential at node B is set to "Vcc - $|$ Vthp $|$ ". In order to turn on N-channel MOS transistor 22, it is necessary to satisfy the following expression (1):

$$Vcc - |Vthp| > Vthn \qquad (1)$$

where Vthn denotes the threshold voltage of N-channel MOS transistor 22. The potential at node A is gradually lowered at a rate corresponding to the time constant determined by the capacitance of capacitor 21 and the ON-resistance of MOS transistor 22 after MOS transistor 22 has been turned on. When the potential at node A has reached the circuit threshold voltage of OR gate 23, the potential of the output terminal of OR gate 23 is changed to a low level and generation of the reset signal is interrupted. In this way, since MOS transistor 22 is kept in the nonconductive state in the circuit until the potential at node B reaches "Vcc - $|$ Vthp $|$ ", the reset signal can be reliably generated even when power source voltage Vcc starts to rise at a slow rate.

However, in the reset signal generating circuit of Fig. 2, a problem occurs when power source voltage Vcc of 2 V which is relatively low but is sufficiently high to ensure the reliable operation of general logic circuits is used. That is, in order to reliably operate the reset signal generating circuit, it is necessary to set power source voltage Vcc higher than the sum of the absolute values of the threshold voltage of MOS transistor 22 and that of MOS transistor 24. In other words, it is necessary to set the threshold voltages so as to satisfy the following expression (2):

$$Vcc > Vthn + |Vthp| \qquad (2)$$

However, even when the threshold voltages theoretically set to satisfy expression (2), expression (2) may not be satisfied if the actual threshold voltages are set to be higher than the designed values. In this case, MOS transistor 22 is kept in the nonconductive state, and the potential at node A is held at a high level so that the potential of the output terminal of OR gate 23 may be kept at the high level, thus continuously generating the reset signal.

In order to prevent the threshold voltage from fluctuating to increase in the manufacturing process, it is necessary to more strictly determine the manufacturing process condition. However, if the thus strictly determined manufacturing process condition is satisfied, the yield will be lowered and therefore it will be practically impossible to set such a strict manufacturing process condition. As a result of this, in the conventional reset generating circuit, the minimum power source voltage is set at a level higher than 2 V. That is, the conventional reset signal generating circuit cannot always generate the reset signal under such a low power source voltage.

As described above, the conventional reset generating circuit has a defect that the operation thereof depends on the length of the rise time of the power source voltage and the amplitude of the power source voltage and it cannot always be reliably operated.

An object of this invention is to provide a reset signal generating circuit which can be operated at a relatively low power source voltage irrespective of the rate of rise of the power source voltage.

This object can be attained by a reset signal generating circuit comprising first and second power source terminals; a first MOS transistor of a first channel type which is connected at one end to the first power source terminal and whose gate is connected to the second power source terminal; a first capacitor connected between the other end of the first MOS transistor and the second power source terminal; a second MOS transistor of a second channel type which is connected at one end to the second power source terminal and whose gate is connected to a connection node between the first MOS transistor and the first capacitor; and a second capacitor connected between the other end of the second MOS transistor and the first power source terminal; wherein a reset signal is generated from a connection node between the second MOS transistor and the second capacitor.

In the reset signal generating circuit according to this invention, a voltage between the gate and drain of, for example, a P-channel MOS transistor is set to be equal to a potential difference between the power source and ground terminals, and the gate potential of an N-channel MOS transistor which is used to interrupt generation of the reset signal is raised to the power source voltage. In a case where the power source voltage rises at a slow rate, a reset signal is generated when power source voltage Vcc rises and becomes higher than a larger one of the absolute value $|V_{thp}|$ of the

threshold voltage of the P-channel MOS transistor and threshold voltage $V_{thn}$ of the N-channel MOS transistor. After this, the output potential is lowered at a rate determined by the time constant of the capacitor and the MOS transistor to interrupt generation of the reset signal.

This invention can be more fully understood from the following detailed description when taken in conjunction with the accompanying drawings, in which:

Fig. 1 is a circuit diagram of the convention reset signal generating circuit;

Fig. 2 is a circuit diagram of another conventional reset signal generating circuit;

Fig. 3 is a circuit diagram of a reset signal generating circuit according to one embodiment of this invention;

Fig. 4 is a circuit diagram of an example of a circuit constituting an OR gate shown in Fig. 3;

Figs. 5 to 8 are waveform diagrams showing the operation of the reset signal generating circuit of Fig. 3; and

Fig. 9 is a circuit diagram according to another embodiment of this invention in which MOS transistors used in the reset signal generating circuit of Fig. 3 are modified into MOS transistors having different channel types.

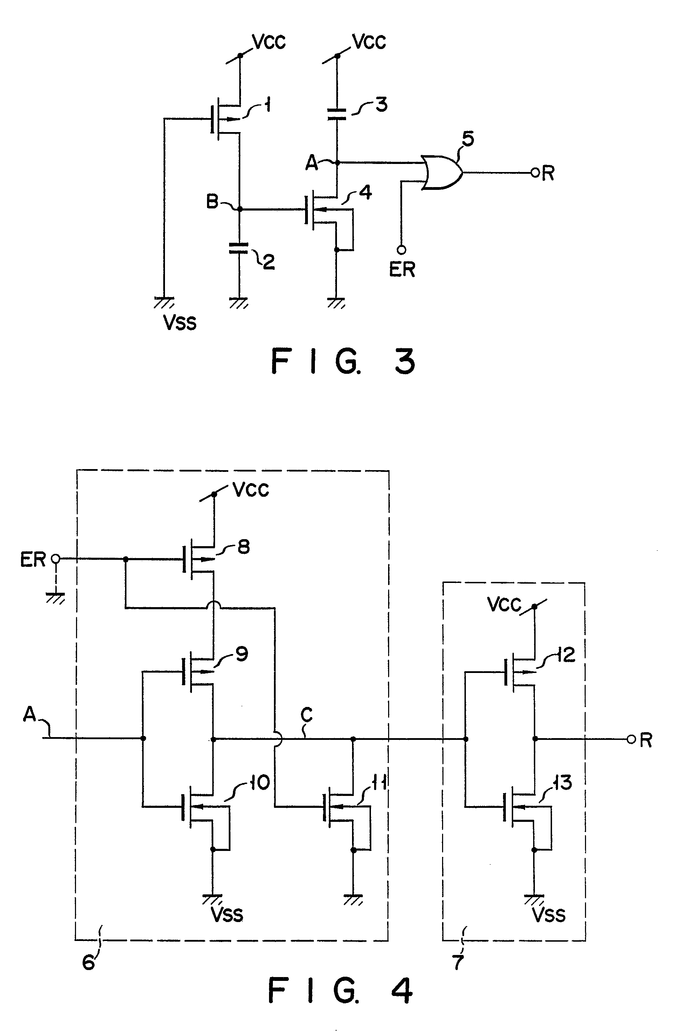

There will now be described a reset signal generating circuit according to one embodiment of this invention with reference to Figs. 3 to 8.

Fig. 3 is a circuit diagram of the reset signal generating circuit. The source of P-channel MOS transistor 1 is connected to power source terminal Vcc and the gate thereof is connected to power source terminal Vss. Further, the drain of MOS transistor 1 is connected to power source terminal Vss via capacitor 2. The drain of N-channel MOS transistor 4 is connected to power source terminal Vcc via capacitor 3, and the source thereof is connected to power source terminal Vss. Further, the gate of MOS transistor 4 is connected to connection node B between the drain of MOS transistor 1 and capacitor 2. Connection node A between MOS transistor 4 and capacitor 3 is connected to a first input terminal of OR gate 5 whose second input terminal is connected to reset terminal ER to which an external reset signal is supplied. Output terminal R of OR gate 5 is used to generate a reset signal.

Fig. 4 shows the detail construction of OR gate 5 shown in Fig. 3. OR gate 5 includes NOR gate 6 and inverter 7 connected to receive an output of NOR gate 6. NOR gate 6 includes a series circuit of P-channel MOS transistors 8 and 9 and N-channel MOS transistor 10, and N-channel MOS transistor 11 connected in parallel with N-channel MOS transistor 10. The gates of MOS transistors 9 and 10 are connected to node A, and the gates of MOS transistors 8 and 11 are connected to reset terminal ER. Reset terminal ER is kept at a low potential level when an external reset signal is not supplied thereto. Therefore, it is possible to assume that the gates of MOS transistors 8 and 11 are normally connected to power source terminal Vss.

Inverter 7 is connected between power source terminals Vcc and Vss, and is constituted by P-channel MOS transistor 12 and N-channel MOS transistor 13 whose gates are connected to output node C of NOR gate 6.

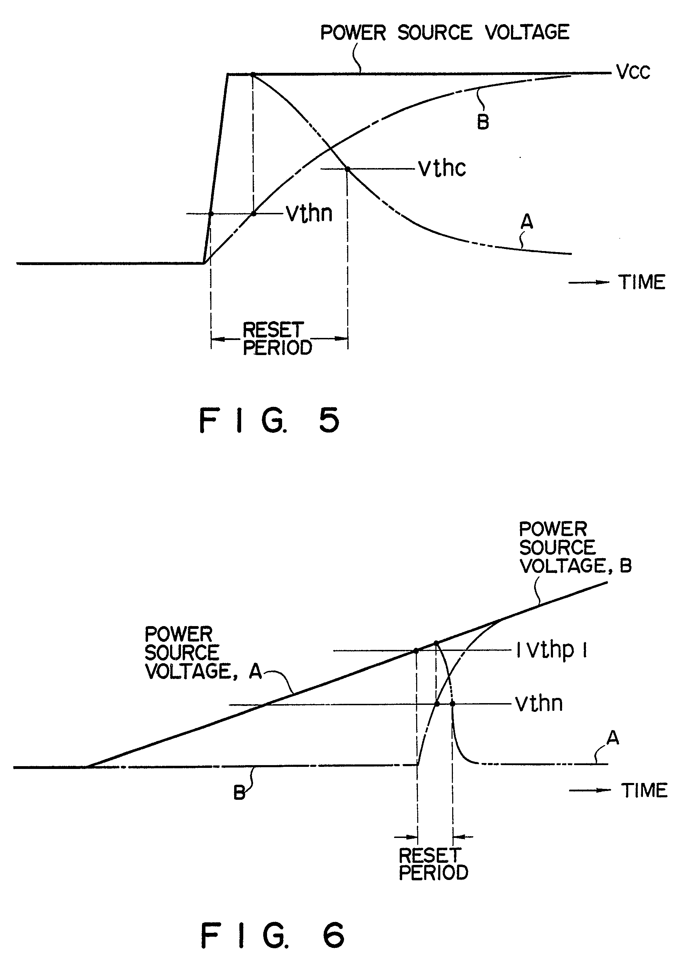

Now, the operation of the reset signal generating circuit is explained with reference to the waveform diagrams shown in Figs. 5 to 8.

Fig. 5 shows the voltage waveform of power source voltage Vcc and voltages at nodes A and B in a case where power source voltage Vcc rises at a rapid rate. When the power source is turned on, the potential at node A rises quickly with the rapid rise of power source voltage Vcc and a reset signal can be generated from the output terminal of OR gate 5. With the rise of power source voltage Vcc, the potential at node B rises at a rate corresponding to the time constant of the ON-resistance of MOS transistor 1 and the capacitance of capacitor 2. When the voltage of node B has reached threshold voltage Vthn of the N-channel MOS transistor, MOS transistor 4 is turned on to discharge capacitor 3. After this, the potential at node A falls at a rate corresponding to the time constant of the ON-resistance of MOS transistor 4 and the capacitance of capacitor 3. When the potential at node A is lowered to circuit threshold voltage Vthc of OR gate 5, the potential of output terminal R is set to a low level, thus interrupting generation of the reset signal.

Figs. 6 to 8 show the voltage waveforms of power source voltage Vcc and voltages at nodes A and B in a case where power source voltage Vcc rises at a slow rate. Fig. 6 shows the case wherein the relation of "| Vthp | > Vthn" is set up between the absolute value | Vthp | of the threshold voltage of the P-channel MOS transistor and threshold voltage Vthn of the N-channel MOS transistor. After the power source is turned on, the potential at node A rises with the rise of power source voltage Vcc. When it has reached voltage Vthn, MOS transistor 10 shown in Fig. 4 is turned on. At this time, the absolute value | Vthp | of the threshold voltage of MOS transistor 9 is larger than voltage Vthn, and MOS transistor 9 is kept in the conductive state. Therefore, the potential at node C is set at a high level. When the potential at node A is further raised and has reached voltage | Vthp |, MOS transistor 9 is turned off, causing the potential at node C to be set to a low level. As a result, P-channel MOS transistor 12 of inverter 7 shown in Fig. 4 is turned on, permitting a reset signal of high level to be generated from output terminal R.

In a case where the potential at node B rises and has reached voltage Vthn, MOS transistor 4 is turned on and capacitor 3 is discharged via MOS transistor 4. After the discharging operation is started, MOS transistor 10 which has been kept in the conductive state is turned off when the potential at node A has reached voltage Vthn. As a result, the potential at node C is set to a high level. Therefore, N-channel MOS transistor 13 of inverter 7 is turned on and the voltage of output terminal R is set to a low level, interrupting generation of the reset signal.

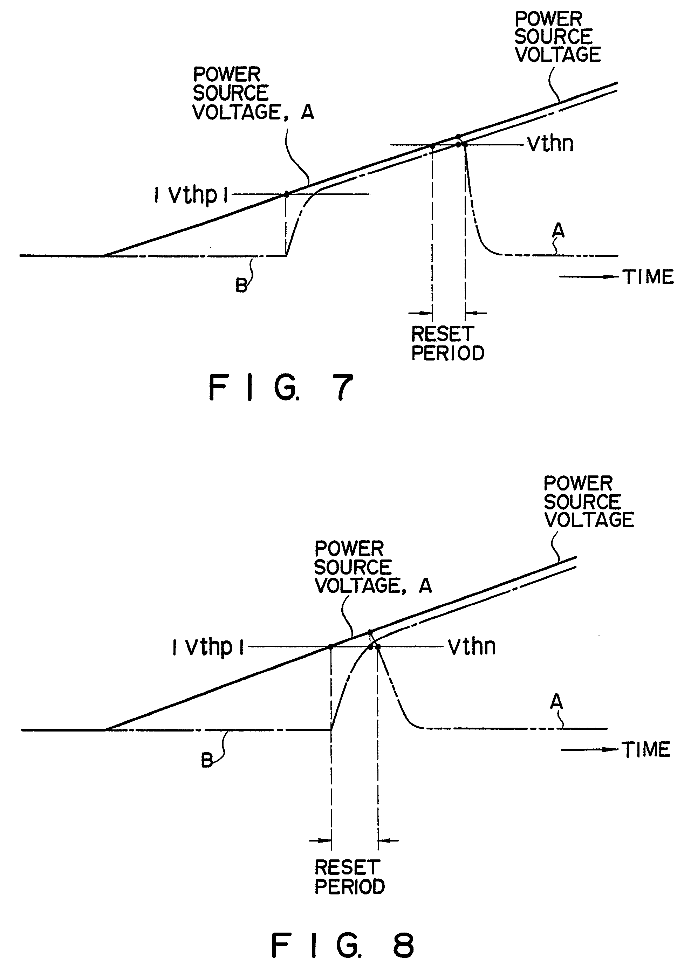

Fig. 7 shows the case wherein the relation of "| Vthp | < Vthn" is set up between the absolute value | Vthp | of the threshold voltage of the P-channel MOS transistor and threshold voltage Vthn of the N-channel MOS transistor. After the power source is turned on, the potential at node A rises with the rise of power source voltage Vcc. When it has reached voltage | Vthp |, MOS transistor 9 shown in Fig. 4 is turned off. At this time, threshold voltage Vthn of MOS transistor 10 is larger than absolute value | Vthp |, and MOS transistor 10 is kept in the nonconductive state. Therefore, the potential at node C is set at a high level. When the potential at node A is further raised and has reached voltage Vthn, MOS transistor 9 is turned on, causing the potential at node C to be set to a low level. As a result, P-channel MOS transistor 12 of inverter 7 shown in Fig. 4 is turned on, permitting a reset signal of high level to be generated from output terminal R.

In a case where power source Vcc rises and has reached voltage | Vthp |, MOS transistor 1 is turned on and capacitor 2 is charged via MOS transistor 1. After the charging operation is started, MOS transistor 10 which has been kept in the conductive state is turned off when the potential at node B has reached voltage Vthn. As a result, the potential at node C is set to a high level. Therefore, N-channel MOS transistor 13 of inverter 7 is turned on and the voltage of output terminal R is set to a low level, thus interrupting generation of the reset signal.

Fig. 8 shows the case wherein the relation of "| Vthp | = Vthn" is set up between the absolute value | Vthp | of the threshold voltage of the P-channel MOS transistor and threshold voltage Vthn of the N-channel MOS transistor. After the power source is turned on, the potential at node A rises with the rise of power source voltage Vcc. When it has reached voltage | Vthp |, MOS transistor 9 shown in Fig. 4 is turned off. At this time, threshold voltage Vthn of MOS transistor 10 is equal to absolute value | Vthp |, and MOS transistor 10 is turned on. Therefore, the potential at node C is set to a low level. As a result, P-channel MOS transistor 12 of inverter 7 shown in Fig. 4 is turned on, permitting a reset signal of high level to be generated from output terminal R.

In a case where power source Vcc rises and has reached voltage | Vthp | and at the same time the potential at node B has reached voltage Vthn, the potential at node A starts to be lowered. At this time, time difference due to time delay in MOS transistor 1 and capacitor 2 shown in Fig. 3 occurs between the time that power source voltage Vcc has reached threshold voltage Vthn and the time that the potential at node B has reached threshold voltage Vthn. In this period of time or during the time difference, power source voltage Vcc continues to rise, and the potential at node A is set to be higher than voltage Vthn. When the potential at node A is lowered to voltage Vthn, MOS transistor 10 shown in Fig. 4 is turned off and MOS transistor 9 is turned on, setting the potential at node C to a high level. As a result, P-channel MOS transistor 13 of inverter 7 is turned on, and the potential at output terminal R is set to a low level, thus interrupting generation of the reset signal.

As described above, in the circuit of the embodiment, the reset signal can be reliably generated not only in the case where power source voltage Vcc rapidly rises but also in the case where it rises at a slow rate. Further, a reset signal is generated if power source voltage Vcc is raised and becomes higher than a larger one of the absolute value | Vthp | of the threshold voltage of the P-channel MOS transistor and threshold voltage Vthn of the N-channel MOS transistor. Therefore, the reset signal generating circuit can be operated at a lower power source voltage in comparison with the case of the conventional circuit shown in Fig. 2.

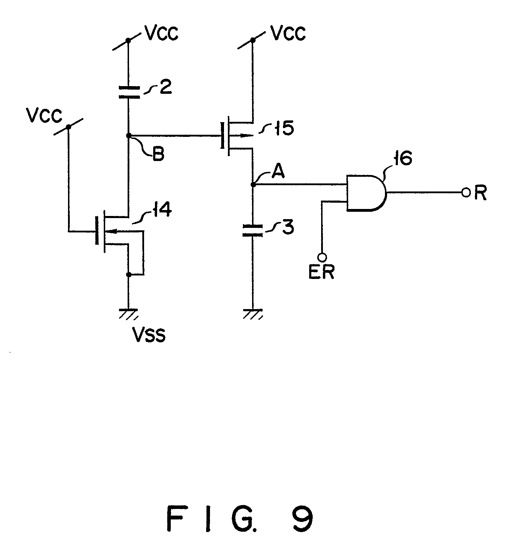

Fig. 9 is a circuit diagram of a reset signal generating circuit according to a second embodiment of this invention. In the reset signal generating circuit, N-channel MOS transistor 14 and P-channel MOS transistor 15 are used instead of P-channel MOS transistor 1 and N-channel MOS transistor 4 in the circuit of Fig. 3, respectively, and AND gate 16 is used instead of OR gate 5. With this construction, a reset signal generated from AND gate 16 is set to a level opposite to that of the reset signal obtained in the reset signal generating circuit of Fig. 3, that is, a reset signal of a low level is generated from the circuit of Fig. 9.

As described above, the reset signal generating circuit according to each of the embodiments can be reliably operated at a power source voltage of as low as 2 V irrespective of the rate of rise of the power source voltage.

## Claims

1. A reset signal generating circuit comprising a first capacitor (3) connected between a first power source terminal (Vcc) and an output node (A); a first MOS transistor (4; 15) of a first channel type whose current path is connected between the output node (A) and a second power source terminal (Vss; Vcc); and a discharging control circuit for turning on said first MOS transistor (4; 15) after a power source voltage which is supplied between said first and second power source terminals (Vcc, Vss; Vss, Vcc) has started to rise; characterized in that said discharging control circuit includes a second MOS transistor (1; 14) of a second channel type which has a gate connected to said second power source terminal (Vss; Vcc) and a current path directly connected between said first power source terminal (Vcc; Vss) and the gate of the first MOS transistor (4; 15) and a second capacitor (2) connected between the gate of said first MOS transistor (4; 15) and said second power source terminal (Vss; Vcc).

2. A reset signal generating circuit according to claim 1, characterized in that said second MOS transistor (1; 14) is of P-channel type, said first MOS transistor (4; 15) is of N-channel type, and said first potential terminal (Vcc; Vss) is set at a potential higher than that of said second potential terminal (Vss; Vcc).

3. A reset signal generating circuit according to claim 2, characterized in that said second MOS transistor (1; 14) is of N-channel type, said first MOS transistor (4; 15) is of P-channel type and the first potential terminal (Vcc; Vss) is set to a potential higher than that of the second potential terminal (Vcc; Vss).

4. A reset signal generating circuit according to claim 1, characterized by further comprising: a logic circuit (5; 16) having a first input terminal connected to a connection node between said first MOS transistor (4; 15) and said second capacitor (3) and a second input terminal connected to receive a reset signal from an external circuit.

5. A reset signal generating circuit according to claim 4, characterized in that said second MOS transistor (1; 14) is of P-channel type, said first MOS transistor (4; 15) is of N-channel type, the first potential terminal (Vcc; Vss) is set to a potential higher than that of the second potential terminal (Vss; Vcc), and said logic circuit (5; 16) is formed of an OR gate circuit (5).

6. A reset sag generating circuit according to claim 4, characterized in that said second MOS transistor (1) is of N-channel type, said first MOS transistor (4) is of P-channel type, the second potential terminal (Vss; Vcc) is set to a potential higher than that of the first potential terminal (Vcc; Vss), and said logic circuit (5; 16) is formed of an AND gate circuit (16).

VCC VCC

—19

A~ ——o R

—20

Vss

# F I G. 1

VCC VCC

—24

—21

A~

B

—22

—23

o R

Vss

# F I G. 2

EP 0 303 257 A1

F I G. 3

F I G. 4

POWER SOURCE VOLTAGE

Vcc

B

vthc

vthn

A

TIME

RESET
PERIOD

F I G. 5

POWER
SOURCE
VOLTAGE, B

POWER
SOURCE
VOLTAGE, A

│vthp│

vthn

A

B

TIME

RESET
PERIOD

F I G. 6

F I G. 7

F I G. 8

F I G. 9

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-4 503 344 (B.A. BRILLHART) <br> * figure 1; abstract; column 4, lines 50-53 * | 1,2 | H 03 K 17/22 |
| Y | | 4,5 | |
| X | PATENT ABSTRACTS OF JAPAN, vol. 8, no. 188 (P-297)(1625), 29th August 1984; & JP - A - 59 77532 (TOSHIBA K.K.) 04-05-1984 <br> * figures 4, 5, 8 of the published application * | 1-3 | |
| Y | PATENT ABSTRACTS OF JAPAN, vol. 7, no. 76 (E-167)(1221), 30th March 1983; & JP - A - 58 5026 (MATSUSHITA DENKI KOGYO K.K.) 12-01-1983 | 4-6 | |
| A | GB-A-2 109 185 (KK SUWA SEIKOSHA) <br> * figrues 1, 3 * | 1 | |
| A | PATENT ABSTRACTS OF JAPAN, vol. 10, no. 293 (E-443)(2349), 4th October 1986; & JP - A - 61 111 018 (TOSHIBA CORP.) 29-05-1986 | 1 | TECHNICAL FIELDS SEARCHED (Int. Cl.4) <br><br> G 06 F 1/00 <br> H 03 K 17/22 |
| A | PATENT ABSTRACTS PF JAPAN, vol. 9, no. 165 (E-327)(1888), 10th July 1985; & JP - A - 60 41322 (TOSHIBA K.K.) 05-03-1985 | 1,3,6 | |
| A | PATENT ABSTRACTS OF JAPAN, vol. 7, no. 164 (P-211)(1309), 19th July 1983; & JP - A - 58 70334 (TOKYO SHIBAURA DENKI K.K.) 26-04-1983 <br> ---      -/- | 1 | |

The present search report has been drawn up for all claims

| Place of search | Date of completion of the search | Examiner |
|---|---|---|
| BERLIN | 16-10-1988 | ARENDT M |

EPO FORM 1503 03.82 (P0401)

European Patent Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| A | EP-A-0 102 618  (NEC CORP.)<br>* figure 1, elements 10, 13; figure 2; page 8, line 16 - page 9, line 9 *<br>--- | 4 | |
| A | IEEE TRANSACTIONS ON CIRCUITS & SYSTEMS, vol. CAS-34, no. 4, April 1987, pages 433-436, New York, US; M.O. AHMAD et al.: "Design of a logic circuit for microprocessor recovery from a power failure and a transient fault"<br>* figure 2 *<br>----- | 4 | |
| | | | TECHNICAL FIELDS SEARCHED (Int. Cl.4) |

The present search report has been drawn up for all claims

| Place of search | Date of completion of the search | Examiner |
|---|---|---|
| BERLIN | 16-10-1988 | ARENDT M |